# FASCICULE DE BREVET EUROPEEN

(11) **EP 4 158 620 B1**
(45) Date de publication et mention de la délivrance du brevet: **02.07.2025**
(21) Numéro de dépôt: 21723309.7
(22) Date de dépôt: 10.05.2021
(51) Int. Cl.: G10L 15/08, G10L 25/78, G10L 15/25, G06F 3/01, H03G 3/34, G10L 21/0208, H04S 7/00, G06V 40/20, H03G 3/30, H03G 3/32

(54) **PROCEDE DE CONTROLE DU VOLUME SONORE**
VERFAHREN ZUR STEUERUNG DER LAUTSTÄRKE
METHOD FOR CONTROLLING SOUND VOLUME

(30) Priorité: 02.06.2020 FR 2005764
(43) Date de publication de la demande: 05.04.2023
(73) Titulaire: Ampere SAS, 92100 Boulogne-Billancourt (FR)
(72) Inventeur: MARTIN, Hervé, 31600 Seysses État (FR); MENDES-CARVALHO, Jose, 31810 Venerque (FR)
(74) Mandataire: Renault Group
(86) Numéro de dépôt international: PCT/EP2021/062372
(87) Numéro de publication internationale: WO 2021/244826

(56) Documents cités:
- JP-A- 2019 137 167
- US-A1- 2020 081 683
- US-A1- 2020 083 856
- GOTTFRIED BEHLER ET AL: "Automatic Loudness Control", PROCEEDINGS OF 20 TH INTERNATIONAL CONGRESS ON ACOUSTICS, 23 August 2010 (2010-08-23), pages 1 - 4, XP055254349

## Description

L'invention concerne le contrôle du volume sonore dans un espace clos ou partiellement clos. Elle trouve une application avantageuse sous la forme d'un procédé de contrôle du volume sonore dans une cabine, la cabine correspondant à un espace clos ou partiellement clos, et notamment dans une cabine constituée par l'habitacle d'un véhicule automobile.

Elle concerne également un produit programme d'ordinateur dont les instructions sont aptes à mettre en œuvre un tel procédé.

Elle concerne en outre un système multimédia mettant en œuvre un tel procédé.

Elle concerne également un véhicule automobile comportant un tel système multimédia.

Il existe dans les véhicules actuels une fonctionnalité de contrôle automatique du volume multimédia en fonction de la vitesse du véhicule, ou Speed Dependent Volume Control en anglais SDVC. Comme son nom l'indique, cette fonctionnalité adapte le niveau du volume en fonction de la vitesse du véhicule. Ainsi, plus le véhicule va vite, plus il y a de bruit dans l'habitacle, plus il est nécessaire d'augmenter le son multimédia pour qu'il reste audible pour les passagers. Grâce au SDVC, l'utilisateur est sensé avoir moins besoin de manipuler le bouton du volume. Cependant aujourd'hui, si deux passagers entament une conversation (plus ou moins soutenue), le volume multimédia ne s'adapte pas.

On connait aussi le document JP2019137167 concernant un procédé de contrôle de sortie audio en fonction de la conversation établie entre les passagers, laquelle est déterminée par une capture d'image et de son, mais aucune notion d'intensité de la conversation n'est déterminée ni prise en considération pour moduler le volume sonore.

De même, on connait le document JP2012025270 concernant un procédé de régulation du volume du son à l'intérieur de l'habitacle en fonction d'éléments captés par des microphones et des images des occupants au moyen d'une caméra pour différencier les sons provenant de l'intérieur de l'habitacle et ceux provenant de l'extérieur, cependant ce procédé ne détermine ni ne prend en considération l'intensité de la conversation pour moduler le volume sonore. On connait également le document DE102016003401 concernant une méthode de détection de conversation dans un véhicule au moyen de micro et de caméra, avec reconnaissance de la parole, mais ce document ne permet pas de moduler le volume sonore en fonction de l'intensité de la conversation.

Le document GOTTFRIED BEHLER ET AL: "Automatic Loudness Control",PROCEEDINGS OF 20 TH INTERNATIONAL CONGRESS ON ACOUSTICS, 23 août 2010 divulgue un procédé de contrôle de volume automatique dans un véhicule, avec une annulation d'écho permettant de soustraire le signal émis par haut-parleur du signal obtenu par le microphone. Ce signal est utilisé pour contrôler le niveau de restitution.

Enfin, le document US 2020/083856 A1 décrit l'ajustement de volume automatique dans un véhicule à partir d'une classification de l'environnement sonore et du contexte déterminé par des caméras.

Les procédés existants ne permettent donc pas d'adapter automatiquement le volume multimédia en fonction de l'intensité de conversation des passagers. Un des buts de l'invention est de remédier à au moins une partie des inconvénients de la technique antérieure en fournissant un procédé de contrôle du volume sonore dans l'habitacle d'un véhicule automobile.

A cette fin, l'invention propose un procédé de contrôle de volume sonore selon la revendication 1.

Grâce à l'invention, le niveau sonore peut s'adapter automatiquement et dynamiquement aux conversations des usagers de manière à ne pas les forcer à modifier eux-même le volume sonore du système multimédia.

Selon une caractéristique avantageuse, la troisième étape utilise un modèle d'apprentissage machine, ce qui permet de préentraîner à la reconnaissance de classes de situation sonore données.

Selon une autre caractéristique avantageuse, la classification de situation sonore cabine distingue au moins trois situations que sont l'absence de communication dans la cabine, la prise de parole d'une seule voix dans la cabine, une communication multi-voix dans la cabine, ce qui permet de classifier les situations sonores courantes. De plus, la classification peut aussi inclure la situation de chant corrélé avec le son du système multimédia, de manière à distinguer cette situation courante et facilement reconnaissable par comparaison des signaux sonores.

Selon une autre caractéristique avantageuse, la communication multi-voix dans la cabine est différenciée entre une communication légère et une communication soutenue, ce qui permet de classer les situations sonores en fonction de leur intensité.

Selon une autre caractéristique avantageuse, la quatrième étape utilise un estimateur de pose de tête, ce qui permet de connaître l'orientation du regard des usagers.

L'avantage lié à la caractéristique selon laquelle la quatrième étape génère en sortie une estimation de la fréquence du regard est de permettre de déterminer l'intensité de communication visuelle dans la cabine.

Selon une autre caractéristique avantageuse, la cinquième étape utilise une cartographie prenant en entrée la situation sonore classifiée et l'intensité de communication visuelle déterminée, ce qui permet de limiter les temps de calculs en alliant robustesse et efficacité.

Selon une autre caractéristique avantageuse, la cinquième étape est personnalisée par passager préalablement identifié, par exemple par adaptation de la cartographie à chaque passager, de prendre en considération le comportement individuel de chaque passager ce qui permet non seulement d'adapter le volume par zone en fonction de la localisation par la caméra des passagers participant à la conversation et ce qui permet parallèlement à chaque passager de corriger individuellement si besoin le volume, et permet ainsi de personnaliser les choix des passagers et les appliquer à chaque haut-parleur de façon différenciée renforcée notamment par la reconnaissance faciale.

Selon une autre caractéristique avantageuse, la cinquième étape comprend une synthèse avec une fonctionnalité SDVC, ce qui permet de prendre en compte à la fois les bruits ambiants et les intensités de conversation et notamment un fonctionnement robuste aussi bien en espace clos que partiellement clos, avec une fenêtre ouverte par exemple.

L'invention concerne également un produit programme d'ordinateur comprenant des instructions de code de programme enregistrées sur un support lisible par ordinateur, comprenant des instructions qui, lorsque le programme est exécuté par l'ordinateur, conduisent celui-ci à mettre en œuvre le procédé selon l'invention, ce qui présente des avantages analogues à ceux du procédé.

L'invention concerne également un système multimédia selon la revendication 8 ce qui présente des avantages analogues à ceux du procédé.

L'invention concerne également un véhicule automobile comprenant un système multimédia selon l'invention, ce qui présente des avantages analogues à ceux du procédé dans un véhicule.

D'autres buts, caractéristiques et avantages de l'invention apparaîtront à la lecture de la description suivante, donnée uniquement à titre d'exemple non limitatif, et faite en référence aux dessins annexés sur lesquels :
- [Fig.1] la figure 1 dont il a déjà été fait mention, illustre schématiquement un procédé de contrôle de volume sonore conforme à l'invention, et,
- [Fig. 2] la figure 2 illustre un système multimédia conforme à l'invention. Pour plus de clarté, les éléments identiques ou similaires sont repérés par des signes de référence identiques sur l'ensemble des figures.

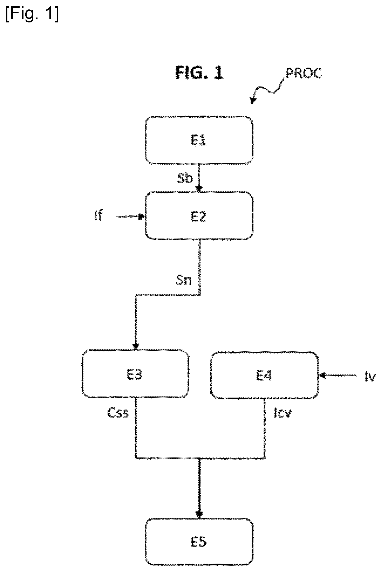

On a schématiquement représenté sur la figure 1 un mode de réalisation du procédé selon l'invention. Le procédé PROC de contrôle de volume sonore généré par un haut-parleur dans une cabine,
caractérisé en ce qu'il comprend :
- une première étape E1 d'acquisition du son dans la cabine, cette première étape E1 est notamment réalisée au moyen de microphones qui sont reliés au système multimédia qui met en œuvre le procédé. En sortie de cette première étape est donc obtenu le son brut Sb dans la cabine, qui est ici par exemple l'habitacle d'un véhicule automobile ;
- une deuxième étape de filtrage par annulation dans le son acquis à la première étape du son généré par le haut-parleur, cette deuxième étape E2 permet de supprimer du son capturé par les microphones le son généré par les hautparleurs. Le mode de fonctionnement est identique aux algorithmes d'annulation d'écho connus. Cette deuxième étape E2 consomme donc en entrée le son brut Sb provenant de la première étape E1 et une information If, par exemple fréquentielle, provenant du système multimédia et correspondant au son généré par les haut-parleurs, à laquelle est alors appliquée par le procédé la fonction de transfert du haut-parleur de manière à intégrer à la composante mécanique du haut-parleur à la composante acoustique purement fréquentielle. De manière alternative, cette information If correspond préférentiellement aux signaux d'excitation des haut-parleurs auxquels sont appliquées par le procédé les réponses fréquentielles des circuits d'amplification électronique, de la mécanique des haut-parleurs et des chemins acoustiques entre les haut-parleurs et les microphones. Cette deuxième étape E2 de filtrage permet de nettoyer le son brut capturé par les microphones en supprimant celui généré par les hautparleurs (musique ou voix lorsqu'on écoute une émission radio). En sortie de cette deuxième étape E2 est donc obtenu le son net Sn dans la cabine;
- une troisième étape E3 de classification de situation sonore cabine à partir du son filtré à la deuxième étape. Cette troisième étape E3 consomme en entrée le son net Sn et utilise un modèle d'apprentissage machine. Le modèle est préalablement entrainé avec une base de données représentant différentes classes de situations sonores prédéterminées, que sont notamment :
- l'absence de communication dans la cabine,
- la prise de parole d'une seule voix dans la cabine,
- une communication multi-voix dans la cabine, la communication multi-voix dans la cabine étant différenciée entre une communication légère et une communication soutenue. Les temps de silence et l'équilibre du temps de parole illustrent par exemple la distinction entre les communication mono et multi-voix ainsi que l'intensité de l'échange dans la communication multi-voix, ainsi un type réponse du tac au tac avec équilibre du temps de parole correspond à une véritable communication multi-voix intense, et non à une communication unidirectionnelle mono-voix (appel téléphonique...),
- des usagers en train de chanter sur la musique émise par le système multimédia IVI.

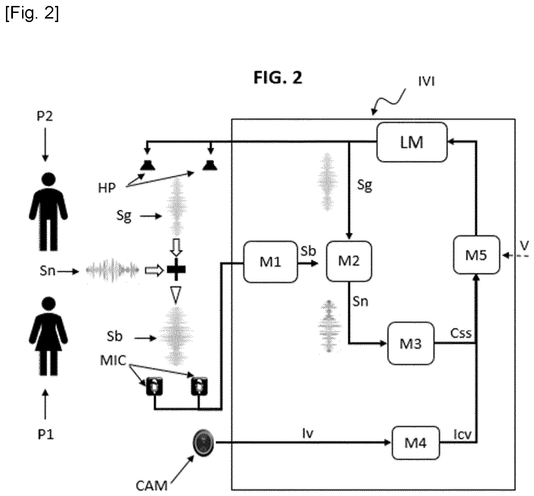

L'utilisation de l'apprentissage machine permet ainsi de classifier une communication en fonction de son intensité d'échange, ce qui permettra par la suite une atténuation de volume différente. En sortie de cette troisième étape E3 est donc obtenu la classe de situation sonore Css dans la cabine;
- une quatrième étape E4 de détermination d'une intensité de communication visuelle dans la cabine, en consommant en entrée une information visuelle Iv provenant d'au moins une caméra. Cette information visuelle Iv permet d'évaluer l'intensité de communication visuelle entre les passagers au travers de regards mutuels. Un algorithme du type pose estimateur (ou head pose estimator en anglais) peut être utilisé. Cet algorithme génère en sortie une estimation de la fréquence du regard (ou frequency of eye-movement en anglais). L'information visuelle Iv permet ainsi de savoir si les passagers de la cabine se regardent régulièrement en fonction de la fréquence du regard obtenue, ce qui permet d'obtenir en sortie de la quatrième étape E4 une intensité de communication visuelle Icv ;
- la cinquième étape E5 contrôle le volume sonore généré par le haut-parleur en fonction de la situation sonore classifiée Css à la troisième étape E3 et de l'intensité de communication visuelle Icv déterminée à la quatrième étape E4. Pour ce faire une cartographie prenant en entrée la situation sonore classifiée Css et l'intensité de communication visuelle Icv déterminée est préférentiellement utilisée. Des exemples de valeurs sont données dans la suite de la description en lien avec la figure 2. Afin de prendre en compte la personnalisation des passagers à cette étape, et si le nombre de haut-parleurs et de microphones dans l'habitacle le permet, la cartographie peut caractériser les situations sonores classifiées Css et les intensités de communication visuelle Icv par siège, ou pour chaque passager, grâce à l'identification par rang, et siège. En effet, dans les étapes précédentes les moyens tels que les microphones MIC ou la caméra CAM identifient géographiquement dans l'habitacle les sons ou les images, que ce soit intrinsèquement par analyse ou par leur emplacement, ces données sont donc disponibles, et les situations sonores classifiées Css et les intensités de communication visuelle Icv peuvent ainsi dès le début être par siège. Cela permet notamment de mettre à jour en fonction de chaque passager la cartographie, et la mémoriser, par exemple si un seul passager modifie volontairement le volume sonore après la mise en oeuvre du procédé. Les éléments de la cartographie pourraient également être mémorisés par passager complètement identifié, que ce soit par reconnaissance faciale ou autre type de reconnaissance si elle est disponible dans le véhicule (empreinte par exemple), de manière à créer une base de données, ainsi les éléments le concernant seront automatiquement mis à jour dans la cartographie en lien avec son emplacement dans l'habitacle dès le début du roulage. De plus à cette étape, est également préférentiellement exécutée la synthèse avec la fonctionnalité SDVC, c'est-à-dire que l'on applique la fonctionnalité SDVC classique qui fournit un volume sonore calculé et on applique à cette valeur la modification de volume déterminée en fonction des intensités de communication Css, Icv, stockée par exemple dans la cartographie.

La figure 2 illustre un système multimédia IVI (de l'anglais In-Vehicle Infotainment System) muni d'un processeur applicatif qui met en œuvre le procédé. Ce système IVI est ici installé dans l'habitacle d'un véhicule automobile, il est relié à au moins deux microphones MIC situés dans la cabine, ces microphones sont préférentiellement face aux passagers P1, P2, et reliés à deux haut-parleurs HP situés dans l'habitacle, par exemple dans la planche de bord et/ou les appuis-tête, et relié à une caméra CAM située dans l'habitacle de manière à percevoir les mouvements de tête des passagers P1, P2. Plusieurs caméras synchronisées entre elles peuvent également être utilisées et leurs images fusionnées en fonction de la taille de l'habitacle.

Les microphones MIC enregistrent le son brut Sb qui est transmis au premier module M1 d'acquisition du son dans l'habitacle, puis traité par un deuxième module M2 de filtrage par annulation dans le son brut Sb acquis par le premier module du son Sg généré par le haut-parleur, ce qui permet d'obtenir en sortie du deuxième module M2 le son net Sn qui correspond au son émis par les passagers P1, P2 incluant les bruits ambiants (bruit moteur, roulement, climatisation, fenêtre ouverte etc.).. On se concentre ici sur les sons émis par les passagers car les bruits ambiants sont, par ailleurs, déjà pris en considération dans la gestion du volume opérée par la fonctionnalité SDVC classique qui s'applique en parallèle. Le troisième module M3 de classification de situation sonore cabine consomme le son net Sn filtré par le deuxième module M2, et génère en sortie la classe de situation sonore Css dans l'habitacle. Parallèlement, le quatrième module M4 détermine une intensité de communication visuelle Icv dans l'habitacle à partir de l'information visuelle Iv provenant de la caméra CAM. Puis, le cinquième module M5 contrôle dynamiquement le volume sonore généré par les haut-parleurs HP en fonction de la situation sonore classifiée par le troisième module M3 et de l'intensité de communication déterminée par le quatrième module M4. Préférentiellement, pour les besoins de la fonctionnalité SDVC ce cinquième module consomme également l'information de vitesse V du véhicule de manière à contrôler automatiquement le volume multimédia en fonction de la vitesse du véhicule. Le cinquième module M5 fait alors la synthèse des informations reçues Css, Icv, V et modifie alors le volume du lecteur multimédia LM (webradio, musique, ...).

Par exemple :
- en cas d'absence de communication dans l'habitacle, il n'y a pas de modification du volume en lien avec les informations reçues d'intensité de communication Css, Icv,
- en cas de prise de parole d'une seule voix dans l'habitacle, une réduction de 3 dB environ est appliquée au volume en lien avec les informations reçues d'intensité de communication Css, Icv,
- en cas de communication multi-voix dans la cabine, s'il s'agit d'une communication légère une réduction de 6 dB environ est appliquée au volume en lien avec les informations reçues d'intensité de communication Css, Icv, et s'il s'agit d'une communication soutenue une réduction de 12 dB environ est appliquée au volume en lien avec les informations reçues d'intensité de communication Css, Icv.
- en cas de chant corrélé avec le son du système multimédia dans l'habitacle, une augmentation de 3dB environ est appliquée au volume, en lien avec les informations reçues d'intensité de communication, essentiellement de classification sonore Css.

Préférentiellement, que ce soit dans un véhicule ou une cabine, lorsqu'une action de réduction du son est appliquée, le comportement des utilisateurs est analysé. Deux cas de figures peuvent se présenter :
1- soit l'utilisateur accepte l'ajustement du son en ne le corrigeant pas
2- soit l'utilisateur n'accepte pas l'ajustement proposé, et modifie manuellement le son à la baisse ou à la hausse

Ces deux cas sont analysés pour être pris en compte dans l'étape E5 future. Par exemple si la réduction est de 12 dB, mais que l'utilisateur corrige en augmentant le volume ensuite de 5 dB, alors le module M5 retient le comportement utilisateur, qu'il peut également associer à un utilisateur identifié, grâce à une reconnaissance faciale par la caméra CAM. Lorsque que le cas se présentera à nouveau, l'algorithme décidera alors de baisser le volume non pas de 12 mais de 7 dB.

De même, en fonction de la position des passagers P1, P2 en rang 1 ou rang 2 du véhicule et du nombre de haut-parleurs dans l'habitacle le volume peut être affecté différemment, par exemple si les passagers sont au rang 1, il est possible de diminuer le haut-parleur avant gauche de 12dB, de diminuer le haut-parleur avant droit de 9dB et de diminuer les haut-parleurs arrière de 3dB en fonction de la position des utilisateurs impliqués dans la conversation, qui est notamment détectée au moyen de la caméra
S'il existe des zones acoustiques privées dans l'habitacle, tel que décrit par exemple dans le brevet FR3078931, l'expérience utilisateur sera plus grande en permettant une atténuation en fonction de la zone. En effet, il y a alors au moins un haut-parleur par zone acoustique privée, c'est-à-dire par passager, ce qui permet non seulement d'adapter le volume par zone en fonction de la localisation par la caméra CAM des passagers participant à la conversation et ce qui permet parallèlement à chaque passager de corriger individuellement si besoin le volume, et permet ainsi de personnaliser les choix des passagers et les appliquer à chaque haut-parleur de façon différenciée renforcée notamment par la reconnaissance faciale.

Grâce à l'invention lorsque des passagers véhicule souhaitent entamer une conversation, le système identifie la situation et baisse lentement le volume, par exemple en cinq à dix secondes de manière à ce que la transition passe inaperçue, sans que l'utilisateur n'ait besoin de modifier manuellement le son multimédia et à la fin de la conversation, le volume reprend lentement le niveau initial notamment si la vitesse n'a pas augmenté.

## Revendications

1. Procédé de contrôle de volume sonore généré par un haut-parleur (HP) dans une cabine comportant des passagers, **caractérisé en ce qu'**il comprend :
- une première étape (E1) d'acquisition du son (Sb) dans la cabine,
- une deuxième étape (E2) de filtrage par annulation dans le son (Sb) acquis à la première étape du son (Sg) généré par le haut-parleur (HP),
- une troisième étape (E3) de classification de situation sonore (Css) cabine à partir du son filtré (Sn) à la deuxième étape (E2),
- une quatrième étape (E4) de détermination d'une intensité de communication visuelle (Icv) dans la cabine, ladite intensité de communication visuelle (Icv) étant représentative d'une fréquence de regards mutuels entre les passagers de la cabine,
- une cinquième étape (E5) de contrôle du volume sonore généré par le haut-parleur (HP) en fonction de la situation sonore classifiée (Css) à la troisième étape (E3) et de l'intensité de communication visuelle (Icv) déterminée à la quatrième étape (E4).

2. Procédé de contrôle de volume sonore selon la revendication précédente **caractérisé en ce que** la troisième étape (E3) utilise un modèle d'apprentissage machine.

3. Procédé de contrôle de volume sonore selon l'une quelconque des revendications précédentes **caractérisé en ce que** la classification de situation sonore cabine distingue au moins trois situations que sont l'absence de communication dans la cabine, la prise de parole d'une seule voix dans la cabine, une communication multi-voix dans la cabine.

4. Procédé de contrôle de volume sonore selon la revendication précédente **caractérisé en ce que** la communication multi-voix dans la cabine est différenciée selon une intensité de l'échange dans la communication multi-voix.

5. Procédé de contrôle de volume sonore selon l'une quelconque des revendications précédentes **caractérisé en ce que** la quatrième étape (E4) utilise un estimateur de pose de tête.

6. Procédé de contrôle de volume sonore selon l'une quelconque des revendications précédentes **caractérisé en ce que** la quatrième étape (E4) génère en sortie une estimation de la fréquence du regard.

7. Procédé de contrôle de volume selon l'une quelconque des revendications précédentes **caractérisé en ce que** la cinquième étape (E5) est personnalisée par passager préalablement identifié.

8. Système multimédia (IVI) muni d'un processeur applicatif, ledit système étant installé dans une cabine comportant des passagers et étant relié à au moins un haut-parleur (HP) situé dans la cabine, à au moins une caméra (CAM) située dans la cabine, et à au moins deux microphones (MIC) situés dans la cabine, **caractérisé en ce qu'**il comprend :
- un premier module (M1) d'acquisition du son dans la cabine,
- un deuxième module (M2) de filtrage par annulation dans le son acquis par le premier module du son généré par le haut-parleur,
- un troisième module (M3) de classification de situation sonore (Css) cabine à partir du son filtré par le deuxième module,
- un quatrième module (M4) de détermination d'une intensité de communication visuelle (Icv) dans la cabine, ladite intensité de communication visuelle (Icv) étant représentative d'une fréquence de regards mutuels entre les passagers de la cabine,
- un cinquième module (M5) de contrôle du volume sonore généré par le haut-parleur (HP) en fonction de la situation sonore classifiée (Css) par le troisième module (M3) et de l'intensité de communication (Icv) déterminée par le quatrième module (M4).

9. Véhicule automobile **caractérisé en ce qu'**il comprend un système multimédia (IVI) selon la revendication précédente.

## Patentansprüche

1. Verfahren zur Steuerung der Lautstärke, die von einem Lautsprecher (HP) in einem Kfz-Innenraum mit Fahrgästen erzeugt wird, **dadurch gekennzeichnet, dass** es Folgendes aufweist:
- einen ersten Schritt (E1) zur Erfassung des Schalls (Sb) im Kfz-Innenraum,
- einen zweiten Schritt (E2) zur Filterung durch Auslöschung des vom Lautsprecher (HP) erzeugten Schalls (Sg) in dem im ersten Schritt erfassten Schall (Sb),
- einen dritten Schritt (E3) zur Klassifizierung der Geräuschsituation (Css) im Kfz-Innenraum über den im zweiten Schritt (E2) gefilterten Schall (Sn),
- einen vierten Schritt (E4) zur Bestimmung einer visuellen Kommunikationsintensität (Icv) im Kfz-Innenraum, wobei die visuelle Kommunikationsintensität (Icv) repräsentativ für eine Häufigkeit des gegenseitigen Anblickens zwischen den Fahrgästen im Kfz-Innenraum ist,
- einen fünften Schritt (E5) zur Steuerung der vom Lautsprecher (HP) erzeugten Lautstärke in Abhängigkeit von der im dritten Schritt (E3) klassifizierten Geräuschsituation (Css) und der im vierten Schritt (E4) bestimmten Intensität der visuellen Kommunikation (Icv).

2. Verfahren zur Steuerung der Lautstärke nach dem vorhergehenden Anspruch, **dadurch gekennzeichnet, dass** der dritte Schritt (E3) ein Modell des maschinellen Lernens verwendet.

3. Verfahren zur Steuerung der Lautstärke nach einem der vorhergehenden Ansprüche, **dadurch gekennzeichnet, dass** die Klassifizierung der Geräuschsituation im Kfz-Innenraum mindestens drei Situationen unterscheidet, nämlich keine Kommunikation im Kfz-Innenraum, Sprechen mit einer einzigen Stimme im Kfz-Innenraum, mehrstimmige Kommunikation im Kfz-Innenraum.

4. Verfahren zur Steuerung der Lautstärke nach dem vorhergehenden Anspruch, **dadurch gekennzeichnet, dass** die mehrstimmige Kommunikation im Kfz-Innenraum nach einer Intensität des Austauschs in der mehrstimmigen Kommunikation differenziert wird.

5. Verfahren zur Steuerung der Lautstärke nach einem der vorhergehenden Ansprüche, **dadurch gekennzeichnet, dass** der vierte Schritt (E4) einen Kopfposen-Schätzer verwendet.

6. Verfahren zur Steuerung der Lautstärke nach einem der vorhergehenden Ansprüche, **dadurch gekennzeichnet, dass** der vierte Schritt (E4) als Ausgabe eine Schätzung der Häufigkeit des Anblickens erzeugt.

7. Verfahren zur Steuerung der Lautstärke nach einem der vorhergehenden Ansprüche, **dadurch gekennzeichnet, dass** der fünfte Schritt (E5) pro zuvor identifiziertem Fahrgast personalisiert wird.

8. Multimediasystem (IVI) mit einem Anwendungsprozessor, wobei das System in einem Kfz-Innenraum mit Fahrgästen installiert ist und mit mindestens einem im Kfz-Innenraum befindlichen Lautsprecher (HP), mit mindestens einer im Kfz-Innenraum befindlichen Kamera (CAM) und mit mindestens zwei im Kfz-Innenraum befindlichen Mikrofonen (MIC) verbunden ist, **dadurch gekennzeichnet, dass** es Folgendes aufweist:
- ein erstes Modul (M1) zur Erfassung des Schalls im Kfz-Innenraum,
- ein zweites Modul (M2) zur Filterung durch Auslöschung des vom Lautsprecher erzeugten Schalls in dem vom ersten Modul erfassten Schall,
- ein drittes Modul (M3) zur Klassifizierung der Geräuschsituation (Css) im Kfz-Innenraum über den im zweiten Modul gefilterten Schall,
- ein viertes Modul (M4) zur Bestimmung einer visuellen Kommunikationsintensität (Icv) im Kfz-Innenraum, wobei die visuelle Kommunikationsintensität (Icv) repräsentativ für eine Häufigkeit des gegenseitigen Anblickens zwischen den Fahrgästen im Kfz-Innenraum ist,
- ein fünftes Modul (M5) zur Steuerung der vom Lautsprecher (HP) erzeugten Lautstärke in Abhängigkeit von der im dritten Modul (M3) klassifizierten Geräuschsituation (Css) und der im vierten Modul (M4) bestimmten Intensität der visuellen Kommunikation (Icv).

9. Kraftfahrzeug, **dadurch gekennzeichnet, dass** es ein Multimediasystem (IVI) nach dem vorhergehenden Anspruch aufweist.

## Claims

1. Method for controlling the volume generated by a loudspeaker (HP) in a cabin containing passengers, **characterized in that** it comprises:
- a first step (E1) of acquiring sound (Sb) in the cabin,
- a second step (E2) of filtering by cancellation from the sound (Sb) acquired in the first step the sound (Sg) generated by the loudspeaker (HP),
- a third step (E3) of classifying a cabin sound situation (Css) based on the sound (Sn) filtered in the second step (E2),
- a fourth step (E4) of determining a visual communication intensity (Icv) in the cabin, said visual communication intensity (Icv) being representative of a frequency with which the passengers of the cabin look at one another,
- a fifth step (E5) of controlling the volume generated by the loudspeaker (HP) depending on the sound situation (Css) classified in the third step (E3) and on the visual communication intensity (Icv) determined in the fourth step (E4).

2. Method for controlling volume according to the preceding claim, **characterized in that** the third step (E3) uses a machine-learning model.

3. Method for controlling volume according to any of the preceding claims, **characterized in that** the classification of the cabin sound situation distinguishes between at least three situations, namely absence of communication from the cabin, a single voice speaking in the cabin, and multi-voice communication in the cabin.

4. Method for controlling volume according to the preceding claim, **characterized in that** multi-voice communication in the cabin is differentiated depending on a loudness of exchange in the multi-voice communication.

5. Method for controlling volume according to any of the preceding claims, **characterized in that** the fourth step (E4) uses a head pose estimator.

6. Method for controlling volume according to any of the preceding claims, **characterized in that** the fourth step (E4) generates as output an estimation of the frequency of eye-movement.

7. Method for controlling volume according to any of the preceding claims, **characterized in that** the fifth step (E5) is personalized by previously identified passenger.

8. Multimedia system (IVI) equipped with an application processor, said system being installed in a cabin containing passengers and being connected to at least one loudspeaker (HP) located in the cabin, to at least one camera (CAM) located in the cabin, and to at least two microphones (MIC) located in the cabin, **characterized in that** it comprises:
- a first module (M1) for acquiring sound in the cabin,
- a second module (M2) for filtering by cancellation from the sound acquired by the first module the sound generated by the loudspeaker,
- a third module (M3) for classifying a cabin sound situation (Css) based on the sound filtered by the second module,
- a fourth module (M4) for determining a visual communication intensity (Icv) in the cabin, said visual communication intensity (Icv) being representative of a frequency with which the passengers of the cabin look at one another,
- a fifth module (M5) for controlling the volume generated by the loudspeaker (HP) depending on the sound situation (Css) classified by the third module (M3) and on the communication intensity (Icv) determined by the fourth module (M4).

9. Motor vehicle, **characterized in that** it comprises a multimedia system (IVI) according to the preceding claim.
